# EUROPÄISCHE PATENTSCHRIFT

(11) **EP 1 623 459 B1**
(45) Veröffentlichungstag und Bekanntmachung des Hinweises auf die Patenterteilung: **25.01.2017**
(21) Anmeldenummer: 04728577.0
(22) Anmeldetag: 21.04.2004
(51) Int. Cl.: H01L 27/115

(54) **BITLEITUNGSSTRUKTUR SOWIE VERFAHREN ZU DEREN HERSTELLUNG**
BIT LINE STRUCTURE AND METHOD FOR THE PRODUCTION THEREOF
STRUCTURE DE LIGNES DE BIT ET SON PROCEDE DE REALISATION

(30) Priorität: 14.05.2003 DE 10321739
(43) Veröffentlichungstag der Anmeldung: 08.02.2006
(73) Patentinhaber: Infineon Technologies AG, 85579 Neubiberg (DE)
(72) Erfinder: KAKOSCHKE, Ronald, 81475 München (DE); SCHULER, Franz, 01109 Dresden (DE); TEMPEL, Georg, 01277 Dresden (DE)
(74) Vertreter: Kindermann, Peter
(86) Internationale Anmeldenummer: PCT/EP2004/050581
(87) Internationale Veröffentlichungsnummer: WO 2004/102658

(56) Entgegenhaltungen:
- WO-A-01/99152
- WO-A2-04/023553
- DE-C- 10 128 211
- DE-C- 10 240 436
- JP-A- 2 062 061
- US-B1- 6 236 077

## Beschreibung

Die vorliegende Erfindung bezieht sich auf eine Bitleitungsstruktur sowie auf ein Verfahren zu deren Herstellung und insbesondere auf eine Sub-100nm-Bitleitungsstruktur sowie ein zugehöriges Herstellungsverfahren, wie es in einer nichtflüchtigen SNOR-Speicherschaltung zur jeweiligen selektiven Ansteuerung von Source- und Drainleitungen verwendet werden kann.

Bei der Realisierung von Speicherschaltungen unterscheidet man grundsätzlich die Speicherarchitektur, wobei die sogenannten NAND- und NOR-Architekturen am häufigsten vertreten sind. In beiden Architekturen werden Halbleiterbauelemente wie z.B. sogenannte Eintransistor-Speicherzellen matrixförmig angeordnet und über sogenannte Wort- und Bitleitungen angesteuert,

Während in NAND-Architekturen eine Vielzahl von Halbleiterbauelementen bzw. Speicherelementen seriell miteinander verbunden sind und über ein gemeinsames Auswahlgatter bzw. einen Auswahltransistor angesteuert werden, sind die jeweiligen Halbleiterbauelemente in NOR-Architekturen parallel bzw. matrixförmig organisiert, wodurch jedes Halbleiterbauelement einzeln ausgewählt werden kann.

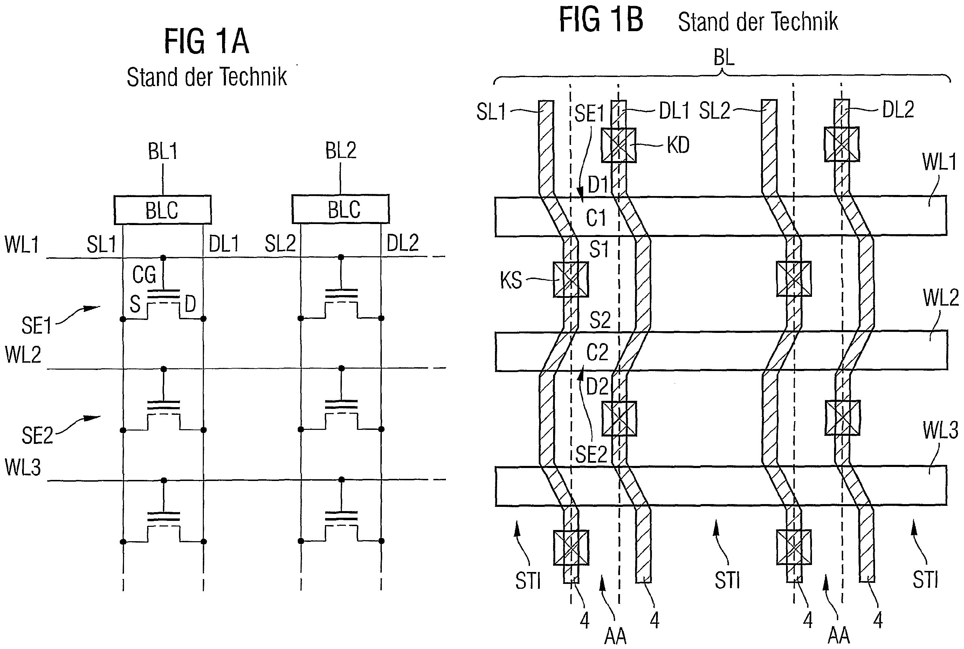

Figur 1A zeigt eine vereinfachte Darstellung einer sogenannten SNOR-Architektur (Selective NOR), bei der im Gegensatz zur NOR-Architektur mit "common source"-Aufbau die einzelnen Speicherelemente SE1, SE2, ... selektiv über eine jeweilige Sourceleitung SL1, SL2, ... und über eine jeweilige Drainleitung DL1, DL2, ... angesteuert werden. Diese selektive Ansteuerung wird beispielsweise über jeweilige Bitleitungssteuerungen BLC durchgeführt, welche sozusagen die gemeinsamen Bitleitungen BL1, BL2, ... realisieren. Auf diese Weise können weitere Shrinks bzw. eine weitergehende Integration von Halbleiterschaltungsanordnungen durchgeführt werden, da die SNOR-Architektur zusammen mit der "Uniform Channel Programmierung" (UCP) nicht auf eine vorbestimmte Mindest-Zelltransistorlänge bzw. Kanallänge angewiesen ist.

Figur 1B zeigt eine vereinfachte Darstellung eines herkömmlichen Layouts der SNOR-Architektur gemäß Figur 1A. Gemäß Figur 1B werden die Schaltelemente bzw. Speicherelemente SE1, SE2, ... in aktiven Bereichen AA eines Halbleitersubstrats ausgebildet, die eine im Wesentlichen gerade streifenförmige Struktur aufweisen. Die Vielzahl von spaltenweise angeordneten streifenförmigen aktiven Bereichen AA werden zeilenweise von ebenfalls streifenförmig ausgebildeten Schichtstapeln bzw. Wortleitungsstapeln WL1, WL2, ... überlagert. Jeder Kreuzungspunkt bzw. Überlappungsbereich eines derartigen streifenförmigen aktiven Bereiches AA mit einem streifenförmig ausgebildeten Wortleitungsstapel WL stellt somit eine Vielzahl von Schaltelementen bzw. Speicherelementen SE dar.

Zum Kontaktieren von jeweiligen Draingebieten D und Sourcegebieten S sind Kontakte notwendig, die üblicherweise in den aktiven Bereichen AA ausgebildet sind, oftmals jedoch auch in ein angrenzendes Isolationsgebiet STI (Shallow Trench Isolation) reichen können. In einer weiteren darüber liegenden Schicht, die vorzugsweise eine erste Metallisierungsschicht darstellt, befinden sich nunmehr die Sourceleitungen SL1, SL2, ... sowie die Drainleitungen DL1, DL2, ... für die jeweiligen Bitleitungen BL. Die Drainleitungen stehen hierbei über entsprechende Kontakte KD mit den zugehörigen Draingebieten D des aktiven Bereiches AA in Verbindung, wobei in gleicher Weise die Sourceleitungen SL über entsprechende Kontakte KS mit den zugehörigen Sourcegebieten S in Verbindung stehen.

Nachteilig ist jedoch bei einer derartigen herkömmlichen Bitleitungsstruktur, dass auf Grund der zusätzlichen Sourceleitungen im Vergleich zu einer "common source"-Architektur eine mehr als doppelt so dichte Metallisierung vorliegt, was einen begrenzenden Faktor für eine weitergehende Integration bzw. weitere Shrinks darstellt.

Zur Verbesserung einer Integrationsdichte wurde daher gemäß Druckschrift DE 100 62 245 A1 vorgeschlagen, die Source- und Drainleitungen sublithographisch als Spacer an einem isolierenden Steg auszubilden und über eine zusätzliche Isolierschicht mit entsprechenden Öffnungen eine Kontaktierung der zugehörigen Source- und Draingebiete zu ermöglichen. Weiterhin ist jedoch der Platzbedarf auf Grund der an der Substratoberfläche ausgebildeten und parallel liegenden Source- und Drainleitungen relativ hoch und verhindert eine weitergehende Integration.

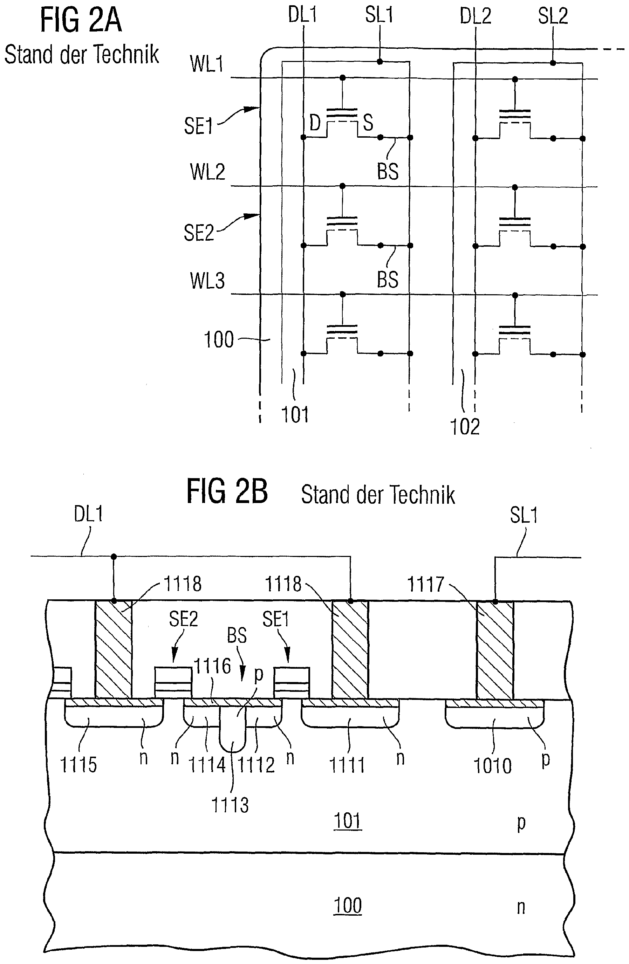

Figuren 2A und 2B zeigen ein vereinfachtes Ersatzschaltbild sowie eine vereinfachte Schnittansicht einer weiteren herkömmlichen Bitleitungsstruktur, wie sie beispielsweise aus der Druckschrift US 6,438,030 B1 bekannt ist.

Gemäß Figuren 2A und 2B ist hierbei wiederum die Drainleitung DL1, DL2, ... als Oberflächenbitleitung an einer Oberfläche eines Substrats 100 ausgebildet, in dem voneinander isolierte p-Wannen 101, 102, ... zur Realisierung einer vergrabenen Sourceleitung SL1, SL3, ... im Halbleitersubstrat ausgebildet sind.

Zur Kontaktierung der jeweiligen Sourcegebiete S bzw. 1114, 1112 mit der Sourceleitung SL bzw. den p-Wannen 101, 102, ... wird ein sogenannter vergrabener Anschlussstreifen BS (Buried Strap) als p-Dotiergebiet 1113 in den Sourcegebieten S bzw. 1114 und 1112 ausgebildet, der mit der p-Wanne 101 bzw. der Sourceleitung in Verbindung steht. Über eine Silizidschicht 1116 ist jedes Sourcegebiet der Schaltelemente bzw. Speicherelemente SE mit dem vergrabenen Anschlussstreifen BS bzw. 1113 und somit mit der p-Wanne 101 bzw. der vergrabenen Sourceleitung elektrisch verbunden. Andererseits sind die Draingebiete D bzw. die Dotiergebiete 1111 und 1115 gemäß Figur 2B über Kontakte 1118 mit der Oberflächenbitleitung DL1 elektrisch verbunden. Darüber hinaus wird jede p-Wanne bzw. vergrabene Sourceleitung 101 über ein p-Diffusionsgebiet 1010 und einen zugehörigen Kontakt mit einer an der Oberfläche geführten Sourceleitung SL1 elektrisch verbunden.

Auf diese Weise kann die Integrationsdichte erheblich verbessert werden, da zumindest ein großer Teil der Sourceleitung als p-Wannengebiet im Halbleitersubstrat "vergraben" ausgebildet ist und die Anforderungen an die Metallisierung oberhalb der Substratoberfläche entsprechend entspannt.

Nachteilig ist hierbei jedoch, dass die üblicherweise aus einem Silizid bestehenden Anschlussschichten 1116 auf Grund notwendiger, jedoch nicht dargestellter Spacer an den Wortleitungsstapeln der Speicherelemente SE lediglich einen geringen Überlapp aufweisen und somit einen hohen Kontaktwiderstand zur p-Wanne 101 bzw. zur Sourceleitung verursachen. In gleicher Weise stellt auch die Leitfähigkeit der p-Wanne 101 bzw. der vergrabenen Sourceleitung einen begrenzenden Faktor dar, da entweder bei einer geringen Dotierung der p-Wanne 101 eine Leitfähigkeit entsprechend gering ist oder bei einer hohen Dotierung der p-Wanne 101 die Durchbruchspannungen des Halbleiterbauelements entsprechend verschlechtert werden.

Ferner ist aus der Druckschrift US 6,008,522 eine vergrabene Bitleitung bekannt, die in einem Graben ausgebildet ist, wobei an ihren oberen Kanten jeweilige Source- und Draingebiete mittels Ausdiffusion selbstjustierend ausgebildet werden.

Die Druckschrift DE 101 28 211 C1 offenbart einen DRAM-Speicher mit Grabenkondensator-Speicherzellen, wobei eine als Kondensatorelektrode dienende Grabenfüllschicht mit einem Kontaktgraben über eine elektrisch leitende Zwischenschicht elektrisch verbunden ist.

Die Druckschrift WO 01/99152 A2 zeigt ebenfalls einen DRAM-Speicher, bei dem eine vergrabene Bitleitung in einem isolierten Graben ausgebildet ist.

Die Druckschrift US-B1-6 236 077 offenbart eine DRAM-Speicherzelle mit einem Zweischicht-Grabenkondensator, wobei ein unterer Abschnitt mit einem hochdotierten Elektrodenmaterial und ein oberer Abschnitt mit einem schwachdotierten Elektrodenmaterial aufgefüllt ist. Zur Vermeidung einer Diffusion befindet sich zwischen oberer und unterer Elektrode eine elektrisch leitende Diffusions-Barrierenschicht.

Die Druckschrift WO 2004/023553 A2, die unter die Bestimmungen gemäß Art. 54(3) EPÜ fällt, offenbart eine Bitleitungsstruktur sowie ein Verfahren zu deren Herstellung, wobei in einem unteren Abschnitt eines Grabens eine vergrabene Bitleitung ausgebildet ist und ein oberer Abschnitt des Grabens mit einer isolierenden Abdeckschicht aufgefüllt ist. Ferner sind im oberen Abschnitt des Grabens elektrisch leitende Verbindungsschichten zum Kontaktieren der vergrabenen Bitleitung ausgebildet.

Ferner offenbart die Druckschrift JP 2 062061 A eine Leitungsstruktur, die in einem tiefen Graben in einem Substrat ausgebildet ist, wobei eine erste Grabenfüllschicht in einem unteren Abschnitt und eine elektrisch leitende Struktur in einem oberen Abschnitt des Grabens ausgebildet ist. Die erste Grabenfüllschicht ist hierbei von der leitenden Struktur durch eine weitere Grabenisolierschicht isoliert.

Der Erfindung liegt demgegenüber die Aufgabe zu Grunde, eine Bitleitungsstruktur sowie ein zugehöriges Herstellungsverfahren zu schaffen, wobei man eine weitergehende Erhöhung der Integrationsdichte bei verbesserten elektrischen Eigenschaften erhält.

Erfindungsgemäß wird diese Aufgabe hinsichtlich der Bitleitungsstruktur durch die Merkmale des Patentanspruchs 1 und hinsichtlich des Verfahrens durch die Maßnahmen des Patentanspruchs 10 gelöst.

Insbesondere durch die Verwendung eines Grabens, der in einem Substrat ausgebildet ist, einer ersten Grabenisolierschicht, die an der Grabenoberfläche ausgebildet ist, einer ersten Grabenfüllschicht, die an der Oberfläche der ersten Grabenisolierschicht ausgebildet ist und einen unteren Abschnitt des Grabens auffüllt, einer zweiten Grabenisolierschicht, die an der Oberfläche der ersten Grabenfüllschicht ausgebildet ist, einer zweiten elektrisch leitenden Grabenfüllschicht, die eine vergrabene Bitleitung ausbildet, die an der Oberfläche der zweiten Grabenisolierschicht ausgebildet ist und einen oberen Abschnitt des Grabens zumindest teilweise bis zur Substratoberfläche auffüllt, zumindest einem ersten Dotiergebiet vom ersten Leitungstyp, das in der Oberfläche des Substrats ausgebildet ist, zumindest einer ersten elektrisch leitenden Anschlussschicht, die zum elektrischen Verbinden des ersten Dotiergebiets mit der zweiten Grabenfüllschicht an der Oberfläche des ersten Dotiergebiets der ersten Grabenisolierschicht und der zweiten Grabenfüllschicht ausgebildet ist, zumindest einem zweiten Dotiergebiet vom ersten Leitungstyp, das in der Oberfläche des Substrats ausgebildet ist, einem Oberflächendielektrikum, das an der Oberfläche des Substrats und des gefüllten Grabens ausgebildet ist, einer Oberflächenbitleitung, die an der Oberfläche des Oberflächendielektrikums ausgebildet ist, und zumindest einer zweiten Anschlussschicht, die zum Verbinden der Oberflächenbitleitung mit dem zumindest zweiten Dotiergebiet im Oberflächendielektrikum ausgebildet ist, wobei die zweite Grabenfüllschicht im oberen Abschnitt des Grabens an der Seite zum anzuschließenden ersten Dotiergebiet ausgebildet ist und die andere Seite des Grabens mit einer dritten Grabenisolierschicht aufgefüllt ist, erhält man eine Bitleitungsstruktur, die selbst in einem Sub-100nm-Bereich wesentlich verbesserte Integrationsdichten liefert und darüber hinaus verbesserte Isolationseigenschaften von benachbarten Zellen bzw. Schalt- oder Speicherelementen ermöglicht. Darüber hinaus sind die Leitungswiderstände insbesondere der vergrabenen Bitleitung wesentlich verringert, wodurch sich Halbleiteranordnungen mit verbesserten Geschwindigkeiten oder verringerten Versorgungsspannungen realisieren lassen. Da keine zusätzlichen Lithographieebenen benötigt werden, kann die Bitleitungsstruktur unter Verwendung von Standardverfahren realisiert werden. Darüber hinaus ist eine Vielzahl der Elemente selbstjustierend ausgebildet, wodurch sich die Anforderungen an die Justiergenauigkeit weitern verringern.

Bei Verwendung eines elektrisch nicht leitenden Materials wie z.B. undotiertes Polysilizium oder SiO₂ für die erste Grabenfüllschicht erhält man hierbei stark verbesserte Isolationseigenschaften bei einfacher Herstellbarkeit. Bei Verwendung eines elektrisch leitenden Materials wie z.B. hochdotiertes Polysilizium oder einem Metall für die erste Grabenfüllschicht können ferner die Abschirmeigenschaften der Gräben bei hervorragenden Isolationseigenschaften verbessert werden.

Vorzugsweise ist die dritte Grabenisolierschicht als flache Grabenisolierung (STI, Shallow Trench Isolation) ausgebildet. Auf diese Weise erhält man auf besonders einfache Weise weiter verbesserte Isoliereigenschaften.

Vorzugsweise wird für das Substrat kristallines Silizium, für die zweite Grabenfüllschicht hochdotiertes Polysilizium und für die erste Anschlussschicht eine Silizidschicht verwendet, wobei zumindest über den zweiten Dotiergebieten eine Silizid-Blockierschicht ausgebildet ist, wodurch sich die vergrabene Bitleitung selbstjustierend und mit minimalem Kontaktwiderstand an die zugehörigen Dotiergebiete anschließen lässt.

Alternativ kann an Stelle der Silizidschicht jedoch auch ein Dummy- bzw. Blind-Kontakt verwendet werden, wobei für das Oberflächendielektrikum eine erste und zweite Dielektrikumschicht ausgebildet wird und der Dummy-Kontakt nur in der ersten Dielektrikumschicht ausgebildet ist. Für den Fall, dass im Standardprozess demzufolge keine Silizid-Blockierschichten abgeschieden und keine Silizidierung durchgeführt wird, erhält man somit eine hochwirksame alternative Kontakttierung der Dotiergebiete an die vergrabene Bitleitung.

Vorzugsweise weist das Substrat einen Mehrschicht-Wannenaufbau auf, wobei der Graben über die unterste Wanne hinaus in das Substrat ragt und die zweite Grabenisolierschicht auf einem Niveau zwischen Substratoberfläche und einer Unterseite einer ersten Wanne liegt. Auf diese Weise können die Isolationseigenschaften zwischen benachbarten Zellen weiter verbessert werden, wobei insbesondere durch die elektrisch leitende Grabenfüllschicht im unteren Abschnitt des Grabens parasitäre Transistoren, Latch-up-Effekte sowie Punch-through-Effekte zuverlässig verhindert werden und die elektrischen Eigenschaften weiter verbessert werden können.

Hinsichtlich des Verfahrens zur Herstellung einer Bitleitungsstruktur wird insbesondere ein Substrat vorbereitet, ein Graben im Substrat ausgebildet, eine erste Grabenisolierschicht an einer Grabenoberfläche des Grabens ausgebildet, eine erste elektrisch leitende Grabenfüllschicht an der Oberfläche der Grabenisolierschicht in einem unteren Abschnitt des Grabens ausgebildet, eine zweite Grabenisolierschicht an der Oberfläche der ersten Grabenfüllschicht ausgebildet, eine zweite elektrisch leitende Grabenfüllschicht als vergrabene Bitleitung an der Oberfläche der zweiten Grabenisolierschicht ausgebildet, die einen oberen Abschnitt des Grabens bis zur Substratoberfläche zumindest teilweise auffüllt und durch die zweite Grabenisolierschicht von der ersten Grabenfüllschicht isoliert ist, wobei die zweite Grabenfüllschicht im oberen Abschnitt des Grabens auf einer Seite bis zur zweiten Grabenisolierschicht entfernt und eine dritte Grabenisolierschicht aufgefüllt wird, zumindest ein erstes und zweites Dotiergebiet in der Oberfläche des Substrats ausgebildet, zumindest eine erste elektrisch leitende Anschlussschicht zum elektrischen Verbinden des zumindest einen ersten Dotiergebiets mit der zweiten Grabenfüllschicht ausgebildet, ein Oberflächendielektrikum an der Substratoberfläche ausgebildet, zumindest eine zweite elektrisch leitende Anschlussschicht im Oberflächendielektrikum ausgebildet, und eine Oberflächenbitleitung an der Oberfläche des Oberflächendielektrikums derart ausgebildet, dass sie die zumindest eine zweite Anschlussschicht kontaktiert.

In den weiteren Unteransprüchen sind weitere vorteilhafte Ausgestaltungen der Erfindung gekennzeichnet.

Die Erfindung wird nachstehend anhand von Ausführungsbeispielen unter Bezugnahme auf die Zeichnung näher beschrieben.

Es zeigen:
- Figuren 1A und 1B: ein vereinfachtes Ersatzschaltbild und eine vereinfachte Draufsicht eines Layouts einer herkömmlichen Bitleitungsstruktur in einer SNOR-Speicherschaltung;
- Figuren 2A und 2B: ein vereinfachtes Ersatzschaltbild und eine zugehörige Schnittansicht einer weiteren herkömmlichen Bitleitungsstruktur;
- Figur 3: eine vereinfachte Draufsicht eines Layouts einer Halbleiterschaltung mit einer erfindungsgemäßen Bitleitungsstruktur;
- Figuren 4A bis 4C: vereinfachte Schnittansichten der Halbleiterschaltungsanordnung gemäß Figur 3 zur Veranschaulichung einer Bitleitungsstruktur gemäß einem ersten Ausführungsbeispiel;
- Figur 5: eine vereinfachte Schnittansicht einer Halbleiterschaltungsanordnung zur Veranschaulichung einer Bitleitungsstruktur gemäß einem zweiten Ausführungsbeispiel;
- Figuren 6A bis 10C: vereinfachte Schnittansichten einer Halbleiterschaltungsanordnung zur Veranschaulichung wesentlicher Verfahrensschritte bei der Herstellung einer Bitleitungsstruktur gemäß einem dritten Ausführungsbeispiel; und
- Figuren 11A bis 11C: vereinfachte Schnittansichten einer Halbleiterschaltungsanordnung zur Veranschaulichung einer Bitleitungsstruktur gemäß einem vierten Ausführungsbeispiel.

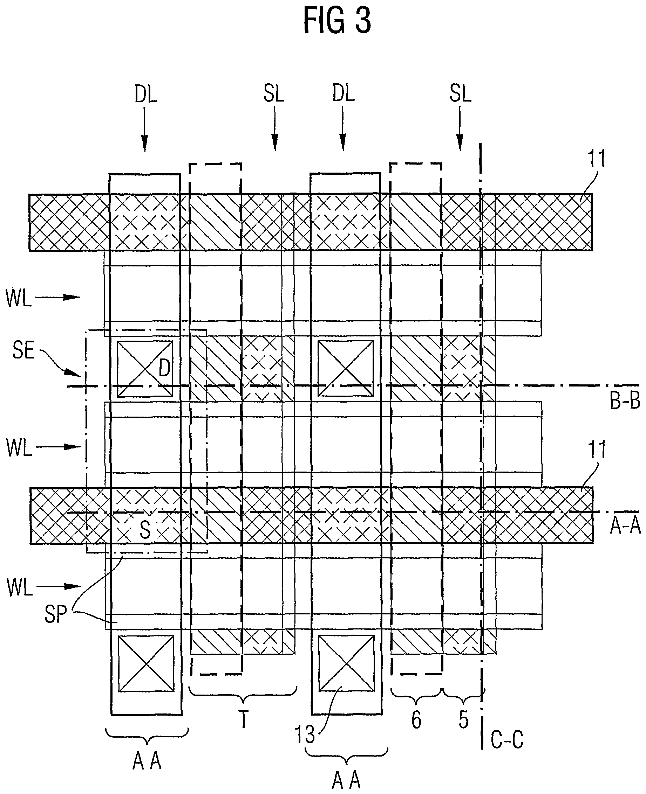

Figur 3 zeigt eine vereinfachte Draufsicht zur Veranschaulichung eines Layouts einer erfindungsgemäßen Bitleitungsstruktur, wie sie beispielsweise in einer SNOR-Halbleiterspeicherschaltung eingesetzt werden kann. Gleiche Bezugszeichen bezeichnen hierbei gleiche oder entsprechende Elemente bzw. Schichten wie in den Figuren 1 und 2.

Gemäß Figur 3 wird in einem Substrat, welches beispielsweise ein Halbleitersubstrat und vorzugsweise kristallines Silizium aufweist, mittels einer Vielzahl von streifenförmigen Grabenisolationen T eine Vielzahl von streifenförmigen aktiven Gebieten AA spaltenförmig im Substrat ausgebildet. Wie beim Stand der Technik gemäß Figur 1B sind Wortleitungsstapel WL senkrecht zu diesen streifenförmigen aktiven Gebieten AA an der Oberfläche des Substrats zeilenförmig ausgebildet, wobei sie zur Realisierung von beispielsweise nichtflüchtigen Speicherelementen SE eine erste Isolierschicht, wie z.B. eine Gateoxidschicht oder eine Tunnelschicht, eine ladungsspeichernde Schicht, wie z.B. ein Floating Gate, eine zweite Isolierschicht, wie z.B. eine ONO-Schichtenfolge, und eine Steuerschicht als eigentliche ansteuernde Wortleitung aufweisen. An den Seitenwänden der Wortleitungsstapel WL sind zu Isolationszwecken Seitenwandisolierschichten bzw. Spacer SP ausgebildet. An jedem Kreuzungspunkt bzw. Überlappungspunkt zwischen den aktiven Gebieten AA und den Wortleitungsstapeln WL wird demzufolge ein Schaltelement bzw. ein nichtflüchtiges Speicherelement SE ausgebildet, welches zur Realisierung einer Feldeffekttransistorstruktur Draingebiete D und Sourcegebiete S als erste und zweite Dotiergebiete an den Seiten der Wortleitungsstapel aufweisen.

Zur Realisierung der erfindungsgemäßen flächenoptimierten Halbleiterschaltung mit verbesserten elektrischen Eigenschaften wird jedoch nunmehr die Bitleitungsstruktur bestehend aus einem Sourceleitungs- und Drainleitungspaar SL und DL nicht ausschließlich in einer Metallisierungsebene an der Oberfläche des Substrats, sondern zum einen als vergrabene Bitleitung bzw. Sourceleitung SL im Graben T innerhalb des Substrats und zum anderen als Oberflächenbitleitung bzw. Drainleitung DL vorzugsweise in einer ersten Metallisierungsebene oberhalb der Substratoberfläche ausgebildet.

Genauer gesagt ist die vergrabene Bitleitung SL in einem oberen Abschnitt der Grabenisolierung bzw. des Grabens T eingebettet und wird über lokal ausgebildete erste Anschlussschichten 11 an die zu kontaktierenden Sourcegebiete S angeschlossen. Andererseits wird die beispielsweise in einer ersten Metallisierungsebene ausgebildete Oberflächenbitleitung bzw. Drainleitung DL über Kontakte 13 mit zugehörigen Draingebieten D der Schaltelemente SE verbunden. Auf diese Weise erhält man eine hinsichtlich des Flächenbedarfs optimierte Bitleitungsstruktur, bei der nicht nur die Pitchdimensionen (Strukturbreite + Strukturabstand) wesentlich verringert sondern darüber hinaus die dielektrischen Eigenschaften und insbesondere die Isolationseigenschaften wesentlich verbessert sind.

Gemäß Figur 3 ist die Oberflächenbitleitung DL streifenförmig oberhalb der aktiven Gebiete AA ausgebildet. Auf Grund dieses geradlinigen Streifendesigns können diese relativ einfach lithographisch definiert werden, weshalb sie insbesondere für Sub-100nm-Strukturen von Bedeutung sind. Grundsätzlich können sie jedoch auch eine andere Form aufweisen.

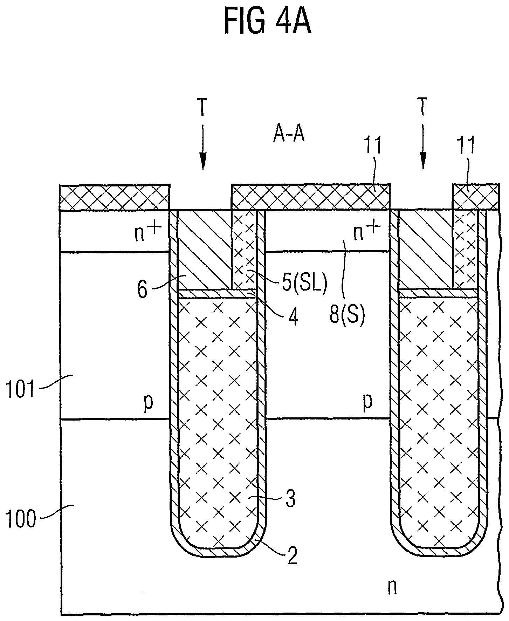

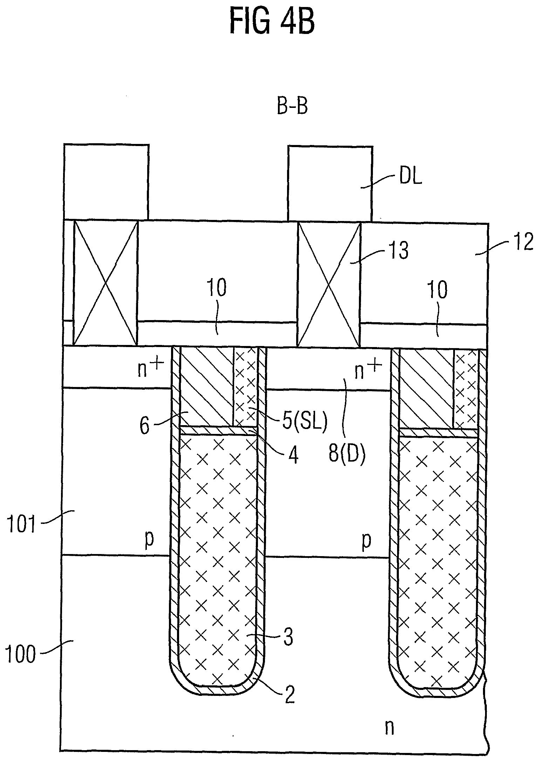

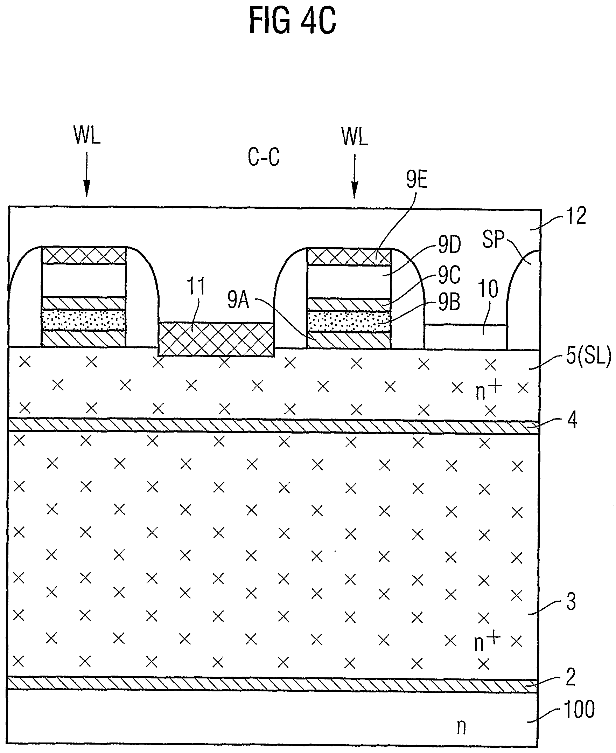

Figur 4 zeigt eine vereinfachte Schnittansicht entlang eines Schnitts A-A gemäß Figur 3, wobei gleiche Bezugszeichen wiederum gleiche Elemente bzw. Schichten bezeichnen und auf eine wiederholte Beschreibung nachfolgend verzichtet wird. Zur Vereinfachung wurden insbesondere die an der Substratoberfläche weitergehend ausgebildeten Schichten für das Zwischendielektrikum sowie für die Drainleitung nicht dargestellt.

Gemäß Figur 4 weist ein Halbleitersubstrat einen Mehrschichtaufbau bzw. einen Mehrfach-Wannenaufbau auf, wobei im Substrat neben einer ersten oberflächennahen p-Wanne 101 ferner eine zweite tiefe n-Wanne 100 ausgebildet sind. Ein derartiger Mehrfach-Wannenaufbau ist insbesondere hinsichtlich seiner Abschirmwirkung und seiner Isolationseigenschaften vorteilhaft, da auch in diesen Regionen des Substrats ausreichende Isolierschichten beispielsweise mittels Raumladungszonen ausgebildet werden können und darüber hinaus komplexe Strukturen realisierbar sind.

Im Halbleitersubstrat bzw. in den zugehörigen Schichten oder Wannen 100 und 101 sind nunmehr die Gräben T ausgebildet, die zumindest über die erste Wanne 101 hinausragen und an ihren Grabenwänden eine Grabenisolierschicht 2 aufweisen. In einem unteren Abschnitt der Gräben T ist nunmehr eine erste Grabenfüllschicht 3 an der Oberfläche der Grabenisolierschicht 2 derart ausgebildet, dass sie den unteren Abschnitt des Grabens vollständig auffüllt. Vorzugsweise wird hierbei hochdotiertes polykristallines Halbleitermaterial verwendet, wobei auch andere elektrisch leitende Materialien wie z.B. Metalle oder elektrisch nicht leitende Materialien wie z.B. undotiertes Halbleitermaterial oder Isoliermaterial (SiO₂ grundsätzlich verwendet werden können. Insbesondere Halbleitermaterialien lassen sich hierbei besonders einfach und ohne Ausbildung von unerwünschten Lücken bzw. voids in den tiefen Gräben abscheiden. Diese erste Grabenfüllschicht 3 dient demzufolge im Wesentlichen der verbesserten Isolation bzw. Abschirmung zwischen den benachbarten Zellen und verhindert insbesondere das Entstehen von parasitären Transistoren entlang des Grabens in Richtung zum Substrat oder von parasitären Transistoren entlang des Grabens von einem Zellenfeld zum benachbarten Zellenfeld. In gleicher Weise werden dadurch auch Punchthrough- bzw. Latch-up-Effekte zuverlässig verhindert.

Zur Realisierung einer hochisolierenden ersten Grabenfüllschicht 3 wird an ihrer Oberfläche eine zweite Grabenisolierschicht 4 ausgebildet, wobei ihr Niveau bzw. ihre relative Höhe vorzugsweise zwischen der Substratoberfläche und der Unterseite der ersten Wanne 101 liegt. Insbesondere im dargestellten Mehrfach-Wannenaufbau können dadurch die Isolationseigenschaften weiter verbessert werden.

Gemäß Figuren 4A bis 4C ist an der Oberfläche der zweiten Grabenisolierschicht 4 ferner eine zweite elektrisch leitende Grabenfüllschicht zum Ausbilden einer eigentlichen vergrabenen Bitleitung SL derart ausgebildet, dass ein oberer Abschnitt des Grabens T zumindest teilweise bis zur Substratoberfläche aufgefüllt ist. Wiederum wird als zweite Grabenfüllschicht 5 vorzugsweise hochdotiertes polykristallines Halbleitermaterial verwendet, wobei jedoch auch alternative elektrisch leitende Materialien und insbesondere Metalle im oberen Abschnitt ausgebildet werden können.

Gemäß Figuren 4A und 4b ist die zweite Grabenfüllschicht 5 im oberen Abschnitt des Grabens T lediglich zur Hälfte ausgebildet, während die andere Hälfte des Grabens mit einer dritten Grabenisolierschicht 6 aufgefüllt ist, die vorzugsweise mittels eines STI-Verfahrens (Shallow Trench Isolation) aus HDP-SiO₂ (High Density Plasma) besteht. Durch dieses nur teilweise Auffüllen des oberen Abschnitts des Grabens T mit elektrisch leitendem zweiten Grabenfüllmaterial können die Isolationseigenschaften auch in diesem Bereich weiter verbessert werden, was insbesondere für Sub-100nm-Strukturen von Bedeutung ist.

Gemäß Figur 4C sind an der Substratoberfläche ferner sogenannte Wortleitungsstapel WL ausgebildet, die im Falle von nichtflüchtigen Speicherelementen eine erste Isolierschicht bzw. Tunnelschicht 9A, eine ladungsspeichernde Schicht 9B, eine zweite Isolierschicht bzw. ONO-Schichtenfolge 9C und eine Steuerschicht 9D aufweisen und entsprechend strukturiert sind. Zur Realisierung von ersten und zweiten Dotiergebieten 8 für die Draingebiete D und die Sourcegebiete S vom ersten Leitungstyp n⁺ können weiterhin Spacer SP an den Seitenwänden der Wortleitungsstapel WL in bekannter Weise ausgebildet sein.

Gemäß dem ersten Ausführungsbeispiel werden nunmehr zum Ausbilden von selbstjustierenden ersten elektrisch leitenden Anschlussschichten 11 zum elektrischen Verbinden der ersten Dotiergebiete S mit der zweiten Grabenfüllschicht 5 an der Oberfläche der zweiten Dotiergebiete D eine Silizid-Blockierschicht 10 ausgebildet, die eine Silizidierung des freiliegenden Halbleitermaterials bzw. Siliziums zuverlässig verhindert. Nach dem ganzflächigen Ausbilden von silizierfähigem Material wird demzufolge nur an den freiliegenden Stellen des Halbleitermaterials eine Umwandlung des silizierfähigen Materials in ein Silizid durchgeführt, wodurch man die ersten elektrisch leitenden Anschlussschichten 11 selbstjustierend für die ersten Dotiergebiete S erhält. Insbesondere für den Fall einer aus Polysilizium bestehenden Grabenfüllschicht 5 können somit die ersten Dotiergebiete S selbstjustierend über die erste Anschlussschicht 11 an die zweite Grabenfüllschicht 5 bzw. die vergrabene Bitleitung mit hervorragenden Anschlusskontakten angeschlossen werden. Für den Fall, dass auch die Steuerschicht 9D aus einem polykristallinen Halbleitermaterial besteht, kann demzufolge auch eine hochleitende Steuerschicht 9E zusätzlich an ihrer Oberfläche ausgebildet werden, wodurch sich die Leitfähigkeit im Wortleitungsstapel weiter verbessert.

Das Ausbilden der ersten und zweiten Dotiergebiete S und D erfolgt hierbei wiederum selbstjustierend mittels Ionenimplantation.

An der Substratoberfläche bzw. an der Oberfläche der Wortleitungsstapel, der Silizid-Bockierschicht 10 sowie der ersten Anschlussschicht 11 wird anschließend ein Oberflächendielektrikum 12 ausgebildet, an dessen Oberfläche wiederum eine Oberflächenbitleitung bzw. eine Drainleitung DL ausgebildet ist. Zum Verbinden der Oberflächenbitleitung DL mit den zweiten Dotiergebieten D wird im Oberflächendielektrikum eine zweite Anschlussschicht 13 vorzugsweise in Form von herkömmlichen Kontakten ausgebildet.

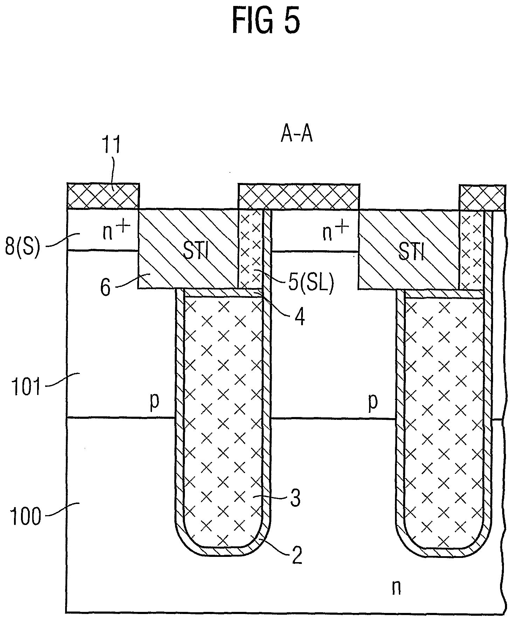

Figur 5 zeigt eine vereinfachte Schnittansicht einer Halbleiterschaltungsordnung zur Veranschaulichung einer Bitleitungsstruktur gemäß einem zweiten Ausführungsbeispiel, wobei gleiche Bezugszeichen gleiche oder entsprechende Schichten oder Elemente bezeichnen wie in Figuren 1 bis 4 und auf eine wiederholte Beschreibung nachfolgend verzichtet wird.

Gemäß Figur 5 kann an Stelle der selbstjustiert ausgebildeten dritten Grabenisolierschicht 6 gemäß Figur 4A auch eine nicht selbst justierte dritte Grabenisolierschicht 6 vorzugsweise mittels einer flachen Grabenisolierung (STI, Shallow Trench Isolation) an der Substratoberfläche im oberen Abschnitt des tiefen Grabens T ausgebildet werden.

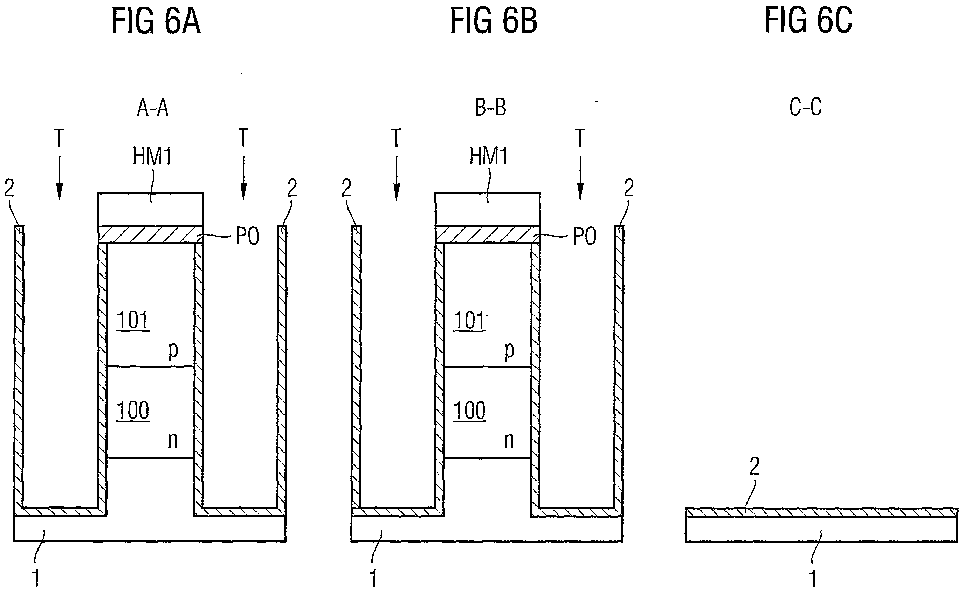

Die Figuren 6A bis 10C zeigen vereinfachte Schnittansichten entlang jeweiliger Schnitte A-A, B-B und C-C gemäß Figur 3 zur Veranschaulichung wesentlicher Verfahrensschritte bei der Herstellung einer Bitleitungsstruktur gemäß einem dritten Ausführungsbeispiel, wobei gleiche Bezugszeichen wiederum gleiche oder entsprechende Elemente bzw. Schichten bezeichnen wie in Figuren 1 bis 5 und auf eine wiederholte Beschreibung nachfolgend verzichtet wird.

Gemäß Figuren 6A bis 6C werden demzufolge nach dem Ausbilden einer ersten p-Wanne 101 und einer zweiten n-Wanne 100 im Halbleitersubstrat 1, die beispielsweise mittels Ionenimplantation durchgeführt wird, zunächst tiefe Gräben T unter Verwendung einer strukturierten ersten Hartmaskenschicht HM1 und einem darunter liegenden Pad-Oxid PO ausgebildet. Vorzugsweise werden hierbei die bei der DRAM-Herstellung verwendeten Verfahren zum Ausbilden von tiefen Gräben durchgeführt, wobei es sich jedoch nicht um lokal begrenzte Gräben, sondern um langgestreckte isolierende Gräben T handelt.

Anschließend wird an der Grabenoberfläche der Gräben T eine erste Grabenisolierschicht 2 vorzugsweise in Form eines sogenannten Lineroxids beispielsweise thermisch ausgebildet. Während die erste Hartmaske HM1 beispielsweise Si₃N₄ aufweist, wird für die erste Grabenisolierschicht 2 und das Pad-Oxid vorzugsweise SiO₂ verwendet.

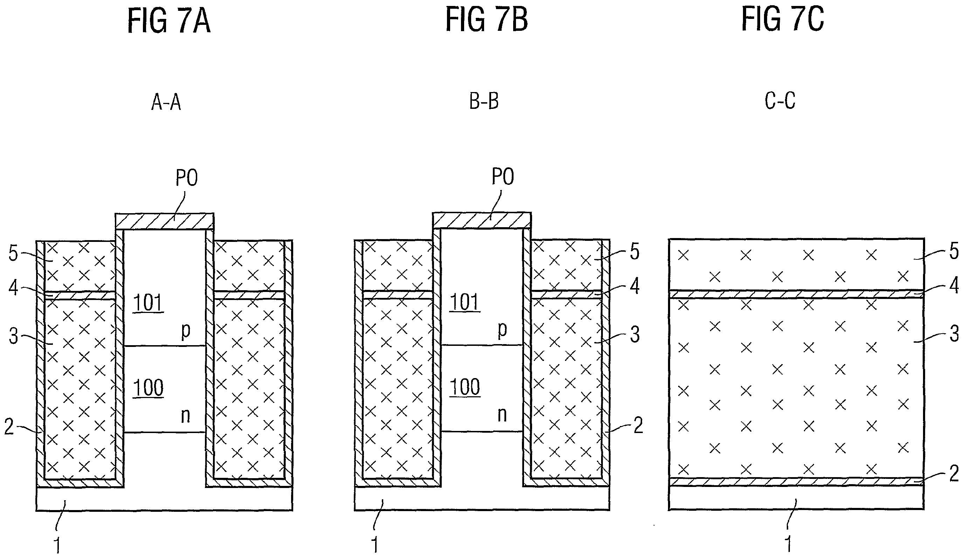

Gemäß Figur 7A bis 7C wird anschließend eine erste elektrisch leitende oder nicht leitende Grabenfüllschicht 3 an der Oberfläche der Grabenisolierschicht 2 in einem unteren Abschnitt des Grabens T ausgebildet, wobei vorzugsweise ein vollständiges Auffüllen des Grabens T mit beispielsweise hochdotiertem oder undotiertem Polysilizium bzw. einem sonstigen elektrisch leitenden oder nicht leitendem Material und ein nachfolgender Rückätzschritt durchgeführt wird.

Anschließend erfolgt das Ausbilden einer zweiten Grabenisolierschicht 4 an der Oberfläche der ersten Grabenfüllschicht 3, wobei bei Verwendung von Polysilizium für die erste Grabenfüllschicht 3 ein Aufwachsen einer Oxidschicht vorzugsweise mittels thermischer Behandlung durchgeführt wird. Zum Ausbilden einer zweiten elektrisch leitenden Grabenfüllschicht 5 als vergrabener Bitleitung SL an der Oberfläche der zweiten Grabenisolierschicht 4, die einen oberen Abschnitt des Grabens T zumindest teilweise bis zur Substratoberfläche auffüllt, wird beispielsweise ein weiterer Abscheidevorgang zum Auffüllen der zweiten Grabenfüllschicht 5 im oberen Abschnitt mittels Polysilizium durchgeführt und anschließend bis zur Substratoberfläche zurückgeätzt, wobei abschließend die aus Si₃N₄ bestehende erste Hartmaskenschicht HM1 entfernt bzw. gestrippt wird.

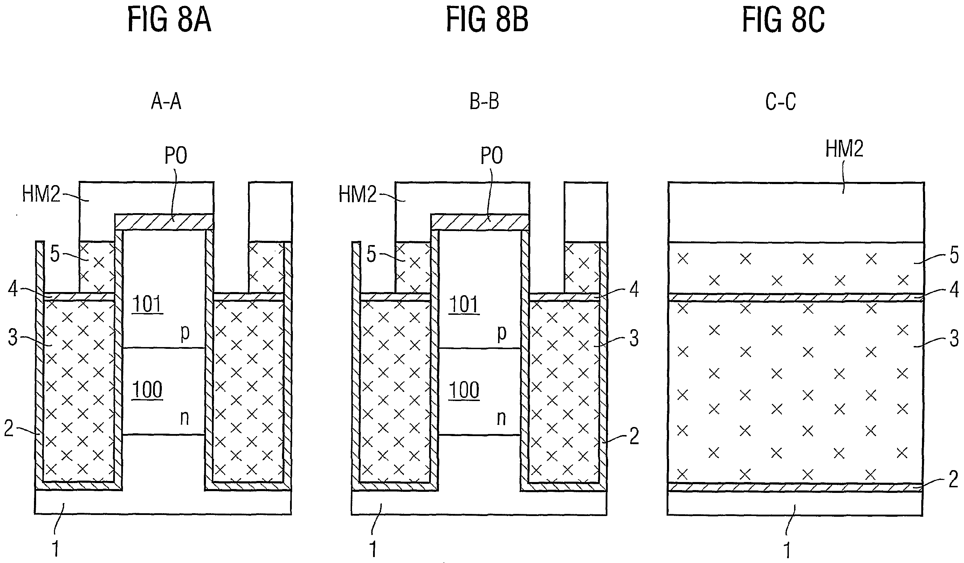

Anschließend wird gemäß Figuren 8A bis 8C unter Verwendung einer zweiten Hartmaskenschicht HM2 beispielsweise mittels eines Standard-STI-Verfahrens ein nicht benötigter Teil der Grabenfüllschicht aus dem oberen Grabenabschnitt entfernt, wobei auch die zweite Hartmaskenschicht HM2 wiederum Si₃N₄ aufweist und insbesondere die für die vergrabene Bitleitung vorgesehene Grabenfüllschicht 5 zumindest teilweise bedeckt. Alternativ kann zu diesem Zeitpunkt ein weiteres Ausbilden einer nicht dargestellten Oxidschicht in den freigelegten Bereichen durchgeführt werden, wodurch sich ein weiteres Lineroxid im freigelegten flachen Graben ergibt.

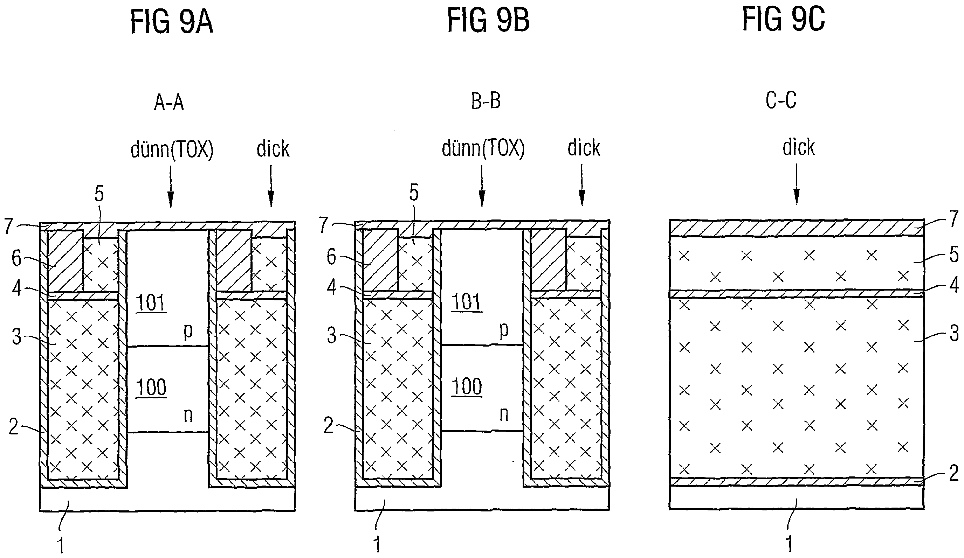

Gemäß Figuren 9A bis 9C erfolgt nunmehr ein sogenanntes Pullback-Ätzen der zweiten Hartmaskenschicht HM2, wodurch diese Schicht zum Teil rückgeätzt und die Kanten abgerundet werden. Anschließend erfolgt beispielsweise mittels eines HDP-Verfahrens (High Density Plasma) eine Abscheidung einer dritten Grabenisolierschicht 6 vorzugsweise als flache Grabenisolierschicht (STI, Shallow Trench Isolation), wodurch der freigelegte obere Abschnitt des Grabens T nunmehr wieder aufgefüllt wird. Zum Entfernen der verbleibenden Pad-Oxidschicht PO sowie der verbleibenden zweiten Hartmaskenschicht HM2 kann ein chemisch-mechanisches Polieren (CMP, Chemical Mechanical Polishing) mit anschließendem HF-Eintauchen durchgeführt werden.

Ferner kann zu diesem Zeitpunkt in einem nicht dargestellten Abschnitt des Halbleitersubstrats beispielsweise ein Hochvolt-Dielektrikum und das Entfernen vorzugsweise eines ersten Teils dieses Hochvolt-Dielektrikums auf dem in den Figuren dargestellten relevanten Zellbereich durchgeführt werden. Anschließend kann gemäß Figuren 9A bis 9C eine erste Oberflächenisolierschicht 7 vorzugsweise thermisch aufgewachsen werden, wobei hierbei im Hochvolt-Bereich ein zweiter Teil des Hochvolt-Dielektrikums ausgebildet wird und im vorliegenden relevanten Zellbereich insbesondere an der Oberfläche der aktiven Bereiche AA ein sehr dünnes Gatedielektrikum bzw. eine Tunnelisolierschicht (TOX) ausgebildet werden kann, die gleichzeitig im Bereich der hochdotierten Grabenfüllschicht 5 (aufgrund der höheren Aufwachsraten) eine wesentlich höhere Dicke aufweist und somit das Entstehen von aktiven Feldeffekttransistorstrukturen zuverlässig verhindert. Auf diese Weise erhält man mit nur einem Verfahrensschritt die üblicherweise über den aktiven Gebieten AA benötigte sehr dünne Tunneloxidschicht, während oberhalb der hochdotierten Polysilizium-Grabenfüllschicht 5 eine zuverlässige Passivierung durch eine wesentlich dickere Schichtdicke erreicht wird.

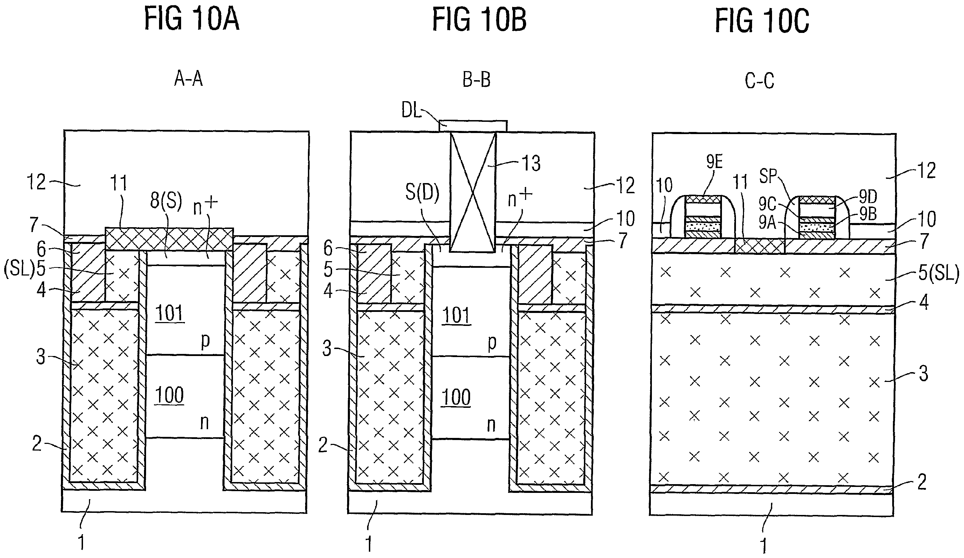

Abschließend werden gemäß Figuren 10A bis 10C mittels herkömmlicher Verfahren beispielsweise die Wortleitungsstapel WL mit ihrer optional zusätzlich ausgebildeten ersten Isolierschicht 9A, ihrer ladungsspeichernden Schicht 9B, ihrer zweiten Isolierschicht bzw. ONO-Schichtenfolge 9C und ihrer Steuerschicht 9D ausgebildet und mit Spacern bzw. Seitenwandisolationsschichten SP versehen.

Anschließend wird eine Silizid-Blockierschicht 10 im Bereich der zweiten Dotiergebiete D ausgebildet, wobei üblicherweise eine Silizid-Blockierschicht ganzflächig abgeschieden und anschließend lithographisch strukturiert wird. Die Silizid-Blockierschicht 10 besteht vorzugsweise aus einer Si₃N₄-Schicht.

Vor dem Ausbilden dieser Silizid-Blockierschicht 10 werden üblicherweise die Dotiergebiete 8 als hochdotiertes erstes bzw. Sourcegebiet S und zweites bzw. Draingebiet D vorzugsweise mittels Ionenimplantation selbst justierend unter Verwendung der Wortleitungsstapel WL bzw. der dazugehörigen Spacer SP in der Oberfläche des Substrats ausgebildet.

Zum Ausbilden der ersten elektrisch leitenden Anschlussschicht 11 zum elektrischen Verbinden der ersten Dotiergebiete bzw. Sourcegebiete S mit der zweiten Grabenfüllschicht 5 bzw. der vergrabenen Bitleitung SL wird beispielsweise zunächst silizierfähiges Material bzw. eine silizierfähige Metallschicht wie z.B. Kobalt, Nickel oder Platin ganzflächig abgeschieden. Anschließend wird eine Umwandlung der Oberflächenschicht des Halbleitermaterials, unter Verwendung des silizierfähigen Materials zum Ausbilden von hochleitfähigen ersten Anschlussbereichen 11 sowie hochleitfähigen Steuerschichten 9E der Wortleitungsstapel WL durchgeführt, wobei an den nicht mit Halbleitermaterial (Silizium) in Berührung stehenden Oberflächen, d.h. an den durch die Silizid-Blockierschicht 10 und sonstige Schichten bedeckten Bereichen, kein Silizid ausgebildet wird, sondern das abgeschiedene Material (Metall) bestehen bleibt, weshalb wiederum mittels eines vorzugsweise nasschemischen Ätzverfahrens eine selektive Rückätzung der abgeschiedenen - aber nicht silizidierten - Metallschicht erfolgen kann. Auf diese Weise kann mittels einer einzigen Maske bzw. Maskenschicht sowohl das selbstjustierende Ausbilden der ersten Anschlussschichten 11 als auch der hochleitfähigen Steuerschicht 9E durchgeführt werden.

Anschließend wird an der Substratoberfläche ein Oberflächendielektrikum 12 als Zwischendielektrikum ausgebildet und darin eine zweite elektrisch leitende Anschlussschicht 13 in Form eines herkömmlichen Kontakts erzeugt. Der Kontakt bzw. die Anschlussschicht 13 besteht vorzugsweise aus einem Kontaktloch bzw. Via zum zweiten Dotiergebiet D, in der eine TiN-Schicht vorzugsweise als Barrierenschicht mit einer W-Schicht als Füllschicht ausgebildet wird. Abschließend wird an der Oberfläche des Oberflächendielektrikums 12, d.h. in der ersten Metallisierungsebene, eine elektrisch leitende Schicht ganzflächig abgeschieden und derart strukturiert, dass sich eine Oberflächenbitleitung bzw. Drainleitung DL ergibt, die über die Kontakte 13 die zweiten Dotiergebiete bzw. Draingebiete D kontaktieren.

Auf diese Weise erhält man eine Bitleitungsstruktur mit hervorragenden elektrischen Eigenschaften, da die vergrabene Bitleitung 5 eine sehr hohe Leitfähigkeit aufweist und über die erste Anschlussschicht 11 optimal mit ihren zugehörigen Dotiergebieten S in Verbindung steht, wobei der mit der ersten Grabenfüllschicht 3 gefüllte untere Abschnitt des Grabens eine hervorragende Isolation bzw. eine hervorragende Abschirmung zwischen Zellbereichen ermöglicht und insbesondere parasitäre Effekte im Halbleitersubstrat zuverlässig verhindert.

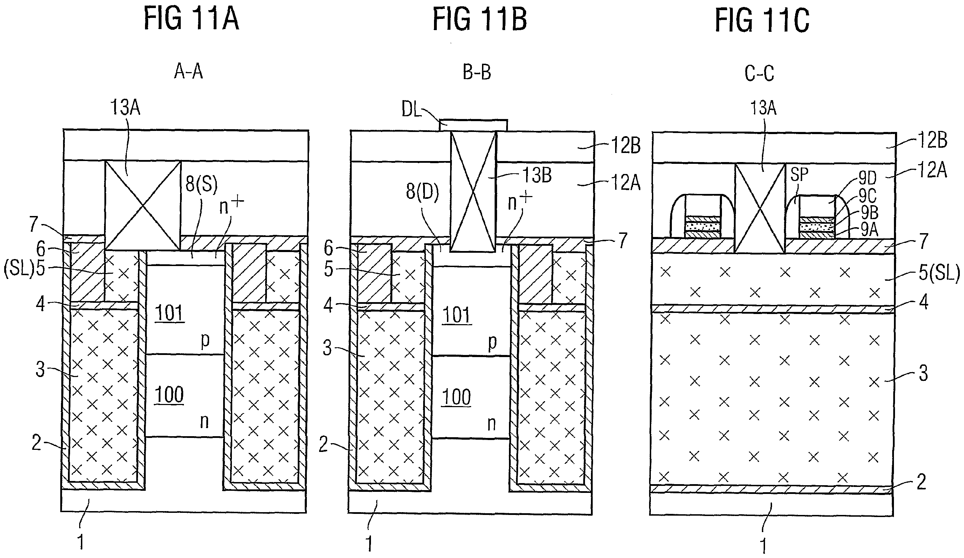

Figuren 11A bis 11C zeigen vereinfachte Schnittansichten der Halbleiterschaltungsanordnung zur Veranschaulichung einer Bitleitungsstruktur gemäß einem vierten Ausführungsbeispiel, wobei gleiche Bezugszeichen gleiche oder entsprechende Elemente bzw. Schichten bezeichnen wie in den Figuren 1 bis 10 und auf eine wiederholte Beschreibung nachfolgend verzichtet wird.

Gemäß Figuren 11A bis 11C kann alternativ zur vorstehend beschriebenen Silizidschicht als hochleitfähige erste Anschlussschicht 11 auch ein sogenannter Dummy- bzw. BlindKontakt als erste Anschlussschicht 13A verwendet werden. Wenn demzufolge in einem Standardverfahren keine Silizid-Blockierschicht 10 sowie die Verwendung von silizierfähigem Material zur Verfügung steht, so kann die erste Anschlussschicht auch durch einen sogenannten Blind-Kontakt 13A realisiert werden.

Hierfür muss das Oberflächendielektrikum lediglich eine erste Dielektrikumschicht 12A und eine darauf ausgebildete zweite Dielektrikumschicht 12B aufweisen, wobei der Blind-Kontakt 13A mittels herkömmlicher Verfahren zur Herstellung von Kontakten lediglich in der ersten Dielektrikumschicht 12A an den Orten im Halbleitersubstrat bzw. der Schaltung ausgebildet wird, an denen die zweite Grabenfüllschicht 5 mit den ersten Dotiergebieten S elektrisch verbunden werden soll. Wiederum kann hierbei nach dem lithographischen Ausbilden eines Kontaktlochs in der ersten Dielektrikumschicht 12A eine TiN-Barrierenschicht sowie eine W-Füllschicht aufgefüllt und anschließend zur Vermeidung von Kurzschlüssen eine zweite Dielektrikumschicht 12B darüber ausgebildet werden. Eventuell vorhandene Isolierschichten 7 werden hierbei entfernt, wodurch man wiederum eine hochleitfähige Kontaktierung unter Verwendung von Standardverfahren erhält. Die zweite Anschlussschicht 13B wird hierbei wieder mittels herkömmlicher Kontaktverfahren durch Ausbilden eines Kontaktlochs bzw. Vias sowohl in der ersten als auch zweiten Dielektrikumschicht 12A und 12B an den Orten der zu kontaktierenden zweiten Dotiergebiete D ausgebildet und in bekannter Weise mit elektrisch leitendem Material gefüllt.

Die Erfindung wurde vorstehend anhand einer nichtflüchtigen SNOR-Halbleiterspeicherschaltung beschrieben. Sie ist jedoch nicht darauf beschränkt und umfasst in gleicher Weise weitere Halbleiterschaltungen, die eine entsprechende Bitleitungsstruktur aufweisen. Ferner ist die Erfindung nicht auf die beschriebenen Silizium-Halbleitersubstrate und zugehörigen Materialien beschränkt, sondern umfasst in gleicher Weise alternative Halbleitermaterialien mit entsprechenden Dotierungen oder Isoliermöglichkeiten. In gleicher Weise können auch die Source- und Draingebiete sowie die zugehörigen Sourceund Drainleitungen entsprechend vertauscht werden.

## Patentansprüche

1. Bitleitungsstruktur mit einem Substrat (1, 100, 101), in dem ein tiefer Graben (T) ausgebildet ist;
einer ersten Grabenisolierschicht (2), die an der Grabenoberfläche ausgebildet ist;
einer ersten Grabenfüllschicht (3), die an der Oberfläche der ersten Grabenisolierschicht (2) ausgebildet ist und einen unteren Abschnitt des Grabens (T) auffüllt;
einer zweiten Grabenisolierschicht (4), die an der Oberfläche der ersten Grabenfüllschicht (3) ausgebildet ist;
einer zweiten elektrisch leitenden Grabenfüllschicht (5), die eine vergrabene Bitleitung (SL) ausbildet, die an der Oberfläche der zweiten Grabenisolierschicht (4) ausgebildet ist und einen oberen Abschnitt des Grabens (T) zumindest teilweise bis zur Substratoberfläche auffüllt, wobei die zweite elektrisch leitende Grabenfüllschicht (5) durch die zweite Grabenisolierschicht (4) von der ersten Grabenfüllschicht (3) isoliert ist;
zumindest einem ersten Dotiergebiet (8, S) vom ersten Leitungstyp (n), das in der Oberfläche des Substrats (101) ausgebildet ist;
zumindest einer ersten elektrisch leitenden Anschlussschicht (11; 13A), die zum elektrischen Verbinden des ersten Dotiergebiets (S) mit der zweiten Grabenfüllschicht (5, SL) an der Oberfläche des ersten Dotiergebiets (8, S), der ersten Grabenisolierschicht (2) und der zweiten Grabenfüllschicht (5, SL) ausgebildet ist;
zumindest einem zweiten Dotiergebiet (8, D) vom ersten Leitungstyp (n), das in der Oberfläche des Substrats (101) ausgebildet ist;
einem Oberflächendielektrikum (7, 10, 12; 12A, 12B), das an der Oberfläche des Substrats (101) und des gefüllten Grabens (T) ausgebildet ist;
einer Oberflächenbitleitung (DL), die an der Oberfläche des Oberflächendielektrikums ausgebildet ist; und
zumindest einer zweiten Anschlussschicht (13), die zum Verbinden der Oberflächenbitleitungen (DL) mit dem zumindest zweiten Dotiergebiet (8, D) im Oberflächendielektrikum ausgebildet ist, **dadurch gekennzeichnet dass**
die zweite Grabenfüllschicht (5) im oberen Abschnitt des Grabens (T) an der Seite zum anzuschließenden ersten Dotiergebiet (S) ausgebildet ist und
die andere Seite des Grabens (T) mit einer dritten Grabenisolierschicht (6) aufgefüllt ist.

2. Bitleitungsstruktur nach Patentanspruch 1,
**dadurch gekennzeichnet, dass** die erste Grabenfüllschicht (3) ein elektrisch nicht leitendes oder ein elektrisch leitendes Material aufweist.

3. Bitleitungsstruktur nach Patentanspruch 1 oder 2,
**dadurch gekennzeichnet, dass** die dritte Grabenisolierschicht (6) als flache Grabenisolierung an der Substratoberfläche ausgebildet ist.

4. Bitleitungsstruktur nach einem der Patentansprüche 1 bis 3, **dadurch gekennzeichnet, dass** das Substrat (1, 100, 101) kristallines Silizium,
die zweite Grabenfüllschicht (5) hochdotiertes Polysilizium, und
die erste Anschlussschicht (11) ein Silizid aufweist, wobei zumindest über den zweiten Dotiergebieten (D) eine Silizid-Blockierschicht (10) ausgebildet ist.

5. Bitleitungsstruktur nach einem der Patentansprüche 1 bis 3, **dadurch gekennzeichnet, dass** das Oberflächendielektrikum eine erste und eine zweite Dielektrikumschicht (12A, 12B) aufweist, und
die erste Anschlussschicht (13A) als Blind-Kontakt nur in der ersten Dielektrikumschicht (12A) ausgebildet ist.

6. Bitleitungsstruktur nach einem der Patentansprüche 1 bis 5, **dadurch gekennzeichnet, dass** die erste und zweite Grabenisolierschicht (2, 4) Siliziumdioxid aufweist.

7. Bitleitungsstruktur nach einem der Patentansprüche 1 bis 6, **dadurch gekennzeichnet, dass** das Substrat zumindest eine erste Wanne (101) vom zweiten Leitungstyp (p) aufweist,
der Graben (T) zumindest über die erste Wanne (101) hinausragt, und
die zweite Grabenisolierschicht (4) auf einem Niveau zwischen Substratoberfläche und Unterseite der ersten Wanne (101) liegt.

8. Bitleitungsstruktur nach Patentanspruch 7,
**dadurch gekennzeichnet, dass** das Substrat ferner eine zweite Wanne (100) vom ersten Leitungstyp (n) aufweist, in der die zumindest eine erste Wanne (101) liegt, und
der Graben (T) über die zweite Wanne (100) hinausragt.

9. Bitleitungsstruktur nach einem der Patentansprüche 1 bis 8, **dadurch gekennzeichnet, dass** das zumindest eine erste Dotiergebiet ein Sourcegebiet (S) und das zumindest eine zweite Dotiergebiet ein Draingebiet (D) einer nichtflüchtigen Halbleiterspeicherzelle darstellt, die als Wortleitungsstapel (WL) eine erste Isolierschicht (9A), eine ladungsspeichernde Schicht (9B), eine zweite Isolierschicht (9C) und eine Steuerschicht (9D) aufweist.

10. Verfahren zur Herstellung einer Bitleitungsstruktur mit den Schritten:
a) Vorbereiten eines Substrats (1, 100, 101);
b) Ausbilden eines Grabens (T) im Substrat;
c) Ausbilden einer ersten Grabenisolierschicht (2) an einer Grabenoberfläche des Grabens (T);
d) Ausbilden einer ersten Grabenfüllschicht (3) an der Oberfläche der Grabenisolierschicht (2) in einem unteren Abschnitt des Grabens (T);
e) Ausbilden einer zweiten Grabenisolierschicht (4) an der Oberfläche der ersten Grabenfüllschicht (3);
f) Ausbilden einer zweiten elektrisch leitenden Grabenfüllschicht (5) als vergrabene Bitleitung (SL) an der Oberfläche der zweiten Grabenisolierschicht (4), die einen oberen Abschnitt des Grabens (T) bis zur Substratoberfläche zumindest teilweise auffüllt und durch die zweite Grabenisolierschicht (4) von der ersten Grabenfüllschicht (3) isoliert ist, wobei die zweite Grabenfüllschicht (5) im oberen Abschnitt des Grabens (T) auf einer Seite bis zur zweiten Grabenisolierschicht (4) entfernt und eine dritte Grabenisolierschicht (6) aufgefüllt wird;
g) Ausbilden zumindest eines Wortleitungsstapels (WL) an der Substratoberfläche;
h) Ausbilden von zumindest einem ersten und einem zweiten Dotiergebiet (S, D) in der Oberfläche des Substrats;
i) Ausbilden von zumindest einer ersten elektrisch leitenden Anschlussschicht (11) zum elektrischen Verbinden des zumindest einen ersten Dotiergebiets (S) mit der zweiten Grabenfüllschicht (5);
j) Ausbilden eines Oberflächendielektrikums (12) an der Substratoberfläche;
k) Ausbilden von zumindest einer zweiten elektrisch leitenden Anschlussschicht (13) im Oberflächendielektrikum (12); und
l) Ausbilden einer Oberflächenbitleitung (DL) an der Oberfläche des Oberflächendielektrikums (12) derart, dass sie die zumindest eine zweite Anschlussschicht (13) kontaktiert.

11. Verfahren nach Patentanspruch 10,
**dadurch gekennzeichnet, dass**
in Schritt d) elektrisch nicht leitendes oder elektrisch leitendes Material als erste Grabenfüllschicht (3) im Graben (T) abgeschieden und zurückgeätzt wird.

12. Verfahren nach Patentanspruch 10 oder 11,
**dadurch gekennzeichnet, dass** in Schritt f) die dritte Grabenisolierschicht (6) mittels eines STI-Verfahrens ausgebildet wird.

13. Verfahren nach einem der Patentansprüche 10 bis 12,
**dadurch gekennzeichnet, dass**
in Schritt a) kristallines Silizium als Substrat verwendet wird,
in Schritt f) hochdotiertes Polysilizium als zweite Grabenfüllschicht (5) abgeschieden wird, und
in Schritt i) ein Silizid als erste Anschlussschicht (11) aus
einem silizierfähigen Material umgewandelt wird, wobei über den zweiten Dotiergebieten (D) eine Silizid-Blockierschicht (10) ausgebildet wurde.

14. Verfahren nach einem der Patentansprüche 10 bis 13,
**dadurch gekennzeichnet, dass**
in Schritt j) eine erste und eine zweite Dielektrikumschicht (12A, 12B) ausgebildet wird und die erste Anschlussschicht (13A) als Blind-Kontakt nur in der ersten Dielektrikumschicht (12A) ausgebildet wird.

15. Verfahren nach einem der Patentansprüche 10 bis 14,
**dadurch gekennzeichnet, dass**
in Schritt c) und in Schritt e) SiO₂ als erste und zweite Grabenisolierschicht (2, 4) ausgebildet wird.

16. Verfahren nach einem der Patentansprüche 10 bis 15,
**dadurch gekennzeichnet, dass**
in Schritt a) zumindest eine erste Wanne (101) vom zweiten Leitungstyp (p) im Substrat ausgebildet wird,
in Schritt b) der Graben (T) zumindest über die erste Wanne (101) hinausragt, und
in Schritt e) die zweite Grabenisolierschicht (4) auf einem Niveau zwischen Substratoberfläche und Unterseite der ersten Wanne (101) ausgebildet wird.

17. Verfahren nach Patentanspruch 16,
**dadurch gekennzeichnet, dass** in Schritt a) ferner eine zweite Wanne (100) vom ersten Leitungstyp (n) im Substrat ausgebildet wird, in der die zumindest eine erste Wanne (101) liegt, und
in Schritt b) der Graben über die zweite Wanne (100) hinausragt.

18. Verfahren nach einem der Patentansprüche 10 bis 17,
**dadurch gekennzeichnet, dass**
in Schritt g) eine erste Isolierschicht (9A), eine ladungsspeichernde Schicht (9B), eine zweite Isolierschicht (9C) und eine Steuerschicht (9D) ausgebildet und zur Realisierung des zumindest einen Wortleitungsstapels (WL) strukturiert wird.

## Claims

1. Bit line structure comprising
a substrate (1, 100, 101), in which a deep trench (T) is formed;
a first trench insulating layer (2), which is formed at the trench surface;
a first trench filling layer (3), which is formed at the surface of the first trench insulating layer (2) and fills a lower section of the trench (T);
a second trench insulating layer (4), which is formed at the surface of the first trench filling layer (3);
a second electrically conductive trench filling layer (5), which forms a buried bit line (SL) which is formed at the surface of the second trench insulating layer (4) and fills an upper section of the trench (T) at least partly up to the substrate surface, wherein the second electrically conductive trench filling layer (5) is insulated from the first trench filling layer (3) by the second trench insulating layer (4);
at least one first doping region (8, S) of the first conduction type (n), which is formed in the surface of the substrate (101);
at least one first electrically conductive connection layer (11; 13A), which is formed for electrically connecting the first doping region (S) to the second trench filling layer (5, SL) at the surface of the first doping region (8, S), the first trench insulating layer (2) and the second trench filling layer (5, SL);
at least one second doping region (8, D) of the first conduction type (n), which is formed in the surface of the substrate (101);
a surface dielectric (7, 10, 12; 12A, 12B), which is formed at the surface of the substrate (101) and of the filled trench (T);
a surface bit line (DL), which is formed at the surface of the surface dielectric; and
at least one second connection layer (13), which is formed for connecting the surface bit lines (DL) to the at least second doping region (8, D) in the surface dielectric, **characterized in that** the second trench filling layer (5) is formed in the upper section of the trench (T) at the side with respect to the first doping region (S) to be connected, and
the other side of the trench (T) is filled with a third trench insulating layer (6).

2. Bit line structure according to Patent Claim 1,
**characterized in that** the first trench filling layer (3) has an electrically nonconductive or an electrically conductive material.

3. Bit line structure according to Patent Claim 1 or 2, **characterized in that** the third trench insulating layer (6) is formed as shallow trench isolation at the substrate surface.

4. Bit line structure according to one of Patent Claims 1 to 3, **characterized in that**
the substrate (1, 100, 101) has crystalline silicon, the second trench filling layer (5) has highly doped polysilicon, and
the first connection layer (11) has a silicide, a silicide blocking layer (10) being formed at least above the second doping regions (D).

5. Bit line structure according to one of Patent Claims 1 to 3, **characterized in that**
the surface dielectric has a first and a second dielectric layer (12A, 12B), and
the first connection layer (13A) is formed as a dummy contact only in the first dielectric layer (12A).

6. Bit line structure according to one of Patent Claims 1 to 5, **characterized in that**
the first and second trench insulating layers (2, 4) have silicon dioxide.

7. Bit line structure according to one of Patent Claims 1 to 6, **characterized in that**
the substrate has at least one first well (101) of the second conduction type (p),
the trench (T) projects at least beyond the first well (101), and
the second trench insulating layer (4) lies at a level between substrate surface and underside of the first well (101).

8. Bit line structure according to Patent Claim 7,
**characterized in that** the substrate furthermore has a second well (100) of the first conduction type (n), in which the at least one first well (101) is situated, and
the trench (T) projects beyond the second well (100).

9. Bit line structure according to one of Patent Claims 1 to 8, **characterized in that**
the at least one first doping region represents a source region (S) and the at least one second doping region represents a drain region (D) of a non-volatile semiconductor memory cell having, as word line stack (WL), a first insulating layer (9A), a charge-storing layer (9B), a second insulating layer (9C) and a control layer (9D).

10. Method for the production of a bit line structure comprising the steps of:
a) preparing a substrate (1, 100, 101);
b) forming a trench (T) in the substrate;
c) forming a first trench insulating layer (2) at a trench surface of the trench (T);
d) forming a first trench filling layer (3) at the surface of the trench insulating layer (2) in a lower section of the trench (T);
e) forming a second trench insulating layer (4) at the surface of the first trench filling layer (3);
f) forming a second electrically conductive trench filling layer (5) as buried bit line (SL) at the surface of the second trench insulating layer (4), which at least partly fills an upper section of the trench (T) up to the substrate surface and is insulated from the first trench filling layer (3) by the second trench insulating layer (4), wherein the second trench filling layer (5), in the upper section of the trench (T) is removed on one side as far as the second trench insulating layer (4) and a third trench insulating layer (6) is filled in;
g) forming at least one word line stack (WL) at the substrate surface;
h) forming at least one first and one second doping region (S, D) in the surface of the substrate;
i) forming at least one first electrically conductive connection layer (11) for electrically connecting the at least one first doping region (S) to the second trench filling layer (5);
j) forming a surface dielectric (12) at the substrate surface;
k) forming at least one second electrically conductive connection layer (13) in the surface dielectric (12); and
l) forming a surface bit line (DL) at the surface of the surface dielectric (12) in such a way that it makes contact with the at least one second connection layer (13).

11. Method according to Patent Claim 10,
**characterized in that**
in step d) electrically nonconductive or electrically conductive material is deposited as the first trench filling layer (3) in the trench (T) and is etched back.

12. Method according to Patent Claim 10 or 11,
**characterized in that**
in step f) the third trench insulating layer (6) is formed by means of an STI method.

13. Method according to one of Patent Claims 10 to 12,
**characterized in that**
in step a) crystalline silicon is used as the substrate,
in step f) highly doped polysilicon is deposited as the second trench filling layer (5), and
in step i) a silicide is converted from a silicideable material as the first connection layer (11), a silicide blocking layer (10) having been formed above the second doping regions (D).

14. Method according to one of Patent Claims 10 to 13,
**characterized in that**
in step j) a first and a second dielectric layer (12A, 12B) are formed and the first connection layer (13A) is formed as a dummy contact only in the first dielectric layer (12A).

15. Method according to one of Patent Claims 10 to 14,
**characterized in that**
in step c) and in step e) SiO₂ is formed as the first and second trench insulating layers (2, 4).

16. Method according to one of Patent Claims 10 to 15,
**characterized in that**
in step a) at least one first well (101) of the second conduction type (p) is formed in the substrate,
in step b) the trench (T) projects at least beyond the first well (101), and
in step e) the second trench insulating layer (4) is formed at a level between substrate surface and underside of the first well (101).

17. Method according to Patent Claim 16,
**characterized in that**
in step a) a second well (100) of the first conduction type (n) is furthermore formed in the substrate, in which well the at least one first well (101) is situated, and
in step b) the trench projects beyond the second well (100).

18. Method according to one of Patent Claims 10 to 17,
**characterized in that**
in step g) a first insulating layer (9A), a charge-storing layer (9B), a second insulating layer (9C) and a control layer (9D) are formed and patterned in order to realize the at least one word line stack (WL).

## Revendications

1. Structure de ligne de bit comprenant:
un substrat (1, 100, 101), dans lequel est constitué un sillon (T) profond;
une première couche (2) isolante du sillon, qui est constituée à la surface du sillon;
une première couche (3) de remplissage du sillon, qui est constituée à la surface de la première couche isolante du sillon et qui remplit une partie inférieure du sillon (T);
une deuxième couche (4) isolante du sillon, qui est constituée à la surface de la première couche (3) isolante du sillon;
une deuxième couche (5) de remplissage du sillon, conductrice de l'électricité, qui constitue une ligne (SL) de bit enterrée, constituée à la surface de la deuxième couche (4) isolante du sillon et qui remplit une partie supérieure du sillon (T) au moins en partie jusqu'à la surface du substrat, la deuxième couche (5) de remplissage du sillon, conductrice de l'électricité, étant isolée de la première couche (3) de remplissage du sillon par la deuxième couche (4) isolante du sillon;
au moins une première région (8, S) de dopage du premier type (n) de conductivité, qui est formée dans la surface du substrat (101);
au moins une première couche (11; 13A) de connexion, conductrice de l'électricité, qui est constituée, pour la liaison électrique de la première région (S) de dopage à la deuxième couche (5, SL) de remplissage du sillon, à la surface de la première région (8, S) de dopage, de la première couche (2) isolante du sillon et de la deuxième couche (5, SL) de remplissage du sillon;
au moins une deuxième région (8, D) de dopage du premier type (n) de conductivité, qui est constituée dans la surface du substrat (101);
un diélectrique (7, 10, 12; 12A, 12B) en surface, qui est constitué à la surface du substrat (101) et du sillon (T) rempli,
une ligne (DL) de bit en surface, qui est constituée à la surface du diélectrique en surface; et
au moins une deuxième couche (13) de connexion, qui est constituée pour relier les lignes (DL) de bit en surface à la au moins une deuxième région (8, D) de dopage dans le diélectrique en surface,
**caractérisé en ce que**
la deuxième couche (5) de remplissage du sillon, dans la partie supérieure du sillon (T), est constituée du côté de la première région (S) de dopage à connecter, et
l'autre côté du sillon (T) est rempli d'une troisième couche (6) isolante du sillon.

2. Structure de ligne de bit suivant la revendication 1,
**caractérisée en ce que** la première couche (3) de remplissage du sillon comporte une matière non conductrice de l'électricité ou conductrice de l'électricité.

3. Structure de ligne de bit suivant la revendication 1 ou 2,
**caractérisée en ce que** la troisième couche (6) isolante du sillon est constituée sous la forme d'un isolant de sillon plan à la surface du substrat.

4. Structure de ligne de bit suivant l'une des revendications 1 à 3,
**caractérisée en ce que** le substrat (1, 100, 101) a du silicium cristallin, la deuxième couche (5) de remplissage du sillon du polysilicium très dopé, et
la première couche (11) de connexion, un siliciure, au moins une couche (10) de blocage de siliciure étant constituée au-dessus des deuxièmes régions (D) de dopage.

5. Structure de ligne de bit suivant l'une des revendications 1 à 3,
**caractérisée en ce que** le diélectrique en surface a une première et une deuxième couche (12A, 12B) de diélectrique, et la première couche (13A) de connexion est constituée sous la forme d'un contact aveugle, seulement dans la première couche (12A) de diélectrique.

6. Structure de ligne de bit suivant l'une des revendications 1 à 5, **caractérisée en ce que** la première et la deuxième couches (2, 4) isolantes du sillon ont du dioxyde de silicium.

7. Structure de ligne de bit suivant l'une des revendications 1 à 6, **caractérisée en ce que** le substrat a au moins un premier caisson (101) du deuxième type (p) de conductivité,
le sillon (T) dépasse au moins du premier caisson (101), et
la deuxième couche (4) isolante du sillon est à un niveau compris entre la surface du substrat et le côté inférieur du premier caisson (101).

8. Structure de ligne de bit suivant la revendication 7,
**caractérisée en ce que** le substrat a en outre un deuxième caisson (100) du premier type (n) de conductivité, dans laquelle se trouve au moins un premier caisson (101), et le sillon (T) dépasse du deuxième caisson (100).

9. Structure de ligne de bit suivant l'une des revendications 1 à 8, **caractérisée en ce que** la au moins une première région de dopage représente une région (S) de source et la au moins deuxième région de dopage, une région (D) de drain d'une cellule de mémoire à semiconducteur non volatile, qui a, comme empilement (WL) de ligne de mot, une première couche (9A) isolante, une couche (9B) d'accumulation de charges, une deuxième couche (9C) isolante et une couche (9D) de commande.

10. Procédé de production d'une structure de ligne de bit comprenant les stades:
a) préparation d'un substrat (1, 100, 101);
b) formation d'un sillon (T) dans le substrat;
c) formation d'une première couche (2) isolante du sillon à une surface du sillon (T);
d) formation d'une première couche (3) de remplissage du sillon à la surface de la couche (2) isolante du sillon dans une partie inférieure du sillon (T);
e) formation d'une deuxième couche (4) isolante du sillon à la surface de la première couche (3) de remplissage du sillon;
f) formation d'une deuxième couche (5) de remplissage du sillon conductrice de l'électricité comme ligne (SL) de bit enterrée, à la surface de la deuxième couche (4) isolante du sillon, qui remplit, au mois en partie, une partie supérieure du sillon (T) jusqu'à la surface du substrat et qui est isolée de la première couche (3) de remplissage du sillon par la deuxième couche (4) isolante du sillon, dans lequel on élimine la deuxième couche (5) de remplissage du sillon dans la partie supérieure du sillon (T), d'un côté, jusqu'à la deuxième couche (4) isolante du sillon et on remplit d'une troisième couche (6) isolante du sillon;
g) on forme au moins un empilement (WL) de ligne de mot à la surface du substrat;
h) on forme au moins une première et une deuxième régions (S, D) de dopage à la surface du substrat;
i) on forme au moins une première couche (11) de connexion conductrice de l'électricité pour relier électriquement la au moins une première région (S) de dopage à la deuxième couche (5) de remplissage du sillon;
j) on forme un diélectrique (12) en surface à la surface du substrat;
k) on forme au moins une deuxième couche (13) de connexion conductrice de l'électricité dans le diélectrique (12) en surface; et
l) on forme une ligne (DL) de bit en surface à la surface du diélectrique (12) en surface de manière à ce qu'elle contacte la au moins une deuxième couche (13) de connexion.

11. Procédé suivant la revendication 10,
**caractérisé en ce que** dans le stade d) on dépose, dans le sillon (T) comme première couche (3) de remplissage du sillon, de la matière non conductrice ou conductrice de l'électricité et on l'attaque en retour.

12. Procédé suivant la revendication 10 ou 11,
**caractérisé en ce que** dans le stade f) on forme la troisième couche (6) isolante du sillon au moyen d'un procédé STI.

13. Procédé suivant l'une des revendications 10 à 12,
**caractérisé en ce que** dans le stade a) on utilise du silicium cristallin comme substrat,
dans le stade f) on dépose du polysilicium très dopé comme deuxième couche (5) de remplissage du sillon, et
dans le stade i) on transforme une matière susceptible d'être siliciée en un siliciure comme première couche (11) de connexion, une couche (10) de blocage de siliciure étant formée au-dessus des deuxièmes régions (D) de dopage.

14. Procédé suivant l'une des revendications 10 à 13,
dans lequel dans le stade j) on forme une première et une deuxième couche (12A, 12B) de diélectrique, et on forme la première couche (13A) de connexion comme contact aveugle seulement dans la première couche (12A) de diélectrique.

15. Procédé suivant l'une des revendications 10 à 14,
**caractérisé en ce que** dans le stade c) et dans le stade e) on forme du SiO₂ comme première et deuxième couches (2, 4) isolantes du sillon.

16. Procédé suivant l'une des revendications 10 à 15,
**caractérisé en ce que**
dans le stade a) on forme dans le substrat au moins un premier caisson (101) du deuxième type (p) de conductivité,
dans le stade b) le sillon (T) dépasse au moins du premier caisson (101), et
dans le stade e) on forme la deuxième couche (4) isolante du sillon à un niveau compris entre la surface du substrat et le côté inférieur du premier caisson (101).

17. Procédé suivant la revendication 16,
**caractérisé en ce que**
dans le stade a) on forme en outre dans le substrat un deuxième caisson (100) du premier type (n) de conductivité, dans lequel se trouve le au moins un premier caisson (101), et dans le stade b) le sillon dépasse du deuxième caisson (100).

18. Procédé suivant l'une des revendications 10 à 17,
**caractérisé en ce que**
dans le stade g) on forme une première couche (9A) isolante, une couche (9B) d'accumulation de charges, une deuxième couche (9C) isolante et une couche (9D) de commande et on les structure pour la réalisation du au moins un empilement (WL) de ligne de mot.
